## Europäisches Patentamt

## European Patent Office

## Office européen des brevets

(11) Veröffentlichungsnummer: **0 224 082**
**A2**

# EUROPÄISCHE PATENTANMELDUNG

(21) Anmeldenummer: **86115308.8**

(22) Anmeldetag: **05.11.86**

(51) Int. Cl.⁴: **H04N 9/68**

(30) Priorität: **16.11.85 DE 3540752**

(43) Veröffentlichungstag der Anmeldung:
**03.06.87 Patentblatt 87/23**

(84) Benannte Vertragsstaaten:
**AT DE FR GB IT SE**

(71) Anmelder: **Blaupunkt-Werke GmbH**
**Robert-Bosch-Strasse 200**
**D-3200 Hildesheim(DE)**

(72) Erfinder: **Gronau, Gerald, Dipl.-Ing.**
**Willi-Plappert-Strasse 18**
**D-3200 Hildesheim(DE)**

(74) Vertreter: **Eilers, Norbert, Dipl.-Phys.**
**Robert-Bosch-Strasse 200**
**D-3200 Hildesheim(DE)**

(54) Schaltungsanordnung mit steuerbarem Verstärkungsfaktor.

(57) Bei einer Schaltungsanordnung mit steuerbarem Verstärkungsfaktor in mehreren Kanälen, insbesondere für die Kontrasteinstellung von Farbfernsehmonitoren, wobei in jedem Kanal zwei emittergekoppelte Transistoren und ein dritter Transistor vorgesehen sind und der Kollektor des jeweils dritten Transistors mit den Emittern des ersten und zweiten Transistors und der Emitter des jeweils dritten Transistors über einen Widerstand mit einem Pol einer Betriebsspannungsquelle verbunden ist, ist den Basisanschlüssen des jeweils ersten Transistors oder den Basisanschlüssen des jeweils zweiten Transistors jeweils gemeinsam eine Steuerspannung zuführbar; ferner sind die Transistoren aus derselben Siliziumscheibe hergestellt und die Schaltung ist als Hybridschaltung aufgebaut.

EP 0 224 082 A2

## Schaltungsanordnung mit steuerbarem Verstärkungsfaktor

Die Erfindung geht aus von einer Schaltungsanordnung nach der Gattung des Hauptanspruchs.

Zur Kontrasteinstellung bei Farbfernsehmonitoren, insbesondere solchen mit Eingängen für die Farbwertsignale Rot, Grün und Blau (RGB), ist es erforderlich, die Verstärkung in den drei für die Farbwertsignale vorgesehenen Kanälen über den gesamten Einstellbereich gleich zu halten. Außerdem wird für breitbandige RGB-Monitore ein großer Frequenzbereich derartiger Schaltungsanordnungen benötigt, der unabhängig von der jeweils eingestellten Verstärkung sein soll.

Die erfindungsgemäße Schaltungsanordnung mit den kennzeichnenden Merkmalen des Hauptanspruchs hat den Vorteil, daß im gesamten Einstellbereich ein guter Gleichlauf der Verstärkungsfaktoren in den drei Kanälen R, G, B möglich ist. Ferner ist besonders vor teilhaft, daß die erfindungsgemäße Schaltungsanordnung gleichspannungsgesteuert ist, wodurch es vermieden wird, daß Videosignale führende Leitungen zu einem unter Umständen räumlich entfernten Bediengerät geführt werden. Außerdem ist eine Einstellung von einem Computer aus über einen Digital/Analog-Wandler möglich. Schließlich kann zur mittleren Strahlstrombegrenzung eines Monitors ein Steuersignal abgeleitet werden, welches ebenfalls auf die erfindungsgemäße Schaltungsanordnung einwirkt.

Schließlich hat die erfindungsgemäße Schaltungsanordnung noch folgende Vorteile: Sie ist universell einsetzbar, weist eine geringe Leistungsaufnahme und einen geringen Raumbedarf auf und ist für Frequenzen von bis zu über 100 MHz geeignet.

Durch die in den Unteransprüchen aufgeführten Maßnahmen sind vorteilhafte Weiterbildungen und Verbesserungen der im Hauptanspruch angegebenen Schaltungsanordnung möglich.

Ein Ausführungsbeispiel der Erfindung ist in der Zeichnung an Hand mehrerer Figuren dargestellt und in der nachfolgenden Beschreibung näher erläutert. Es zeigt:

Fig. 1 ein Schaltbild einer erfindungsgemäßen Schaltungsanordnung und

Fig. 2 ein Schaltbild einer zusätzlichen Beschaltung zu einer erfindungsgemäßen Schaltungsanordnung.

Gleiche Teile sind in den Figuren mit gleichen Bezugszeichen versehen.

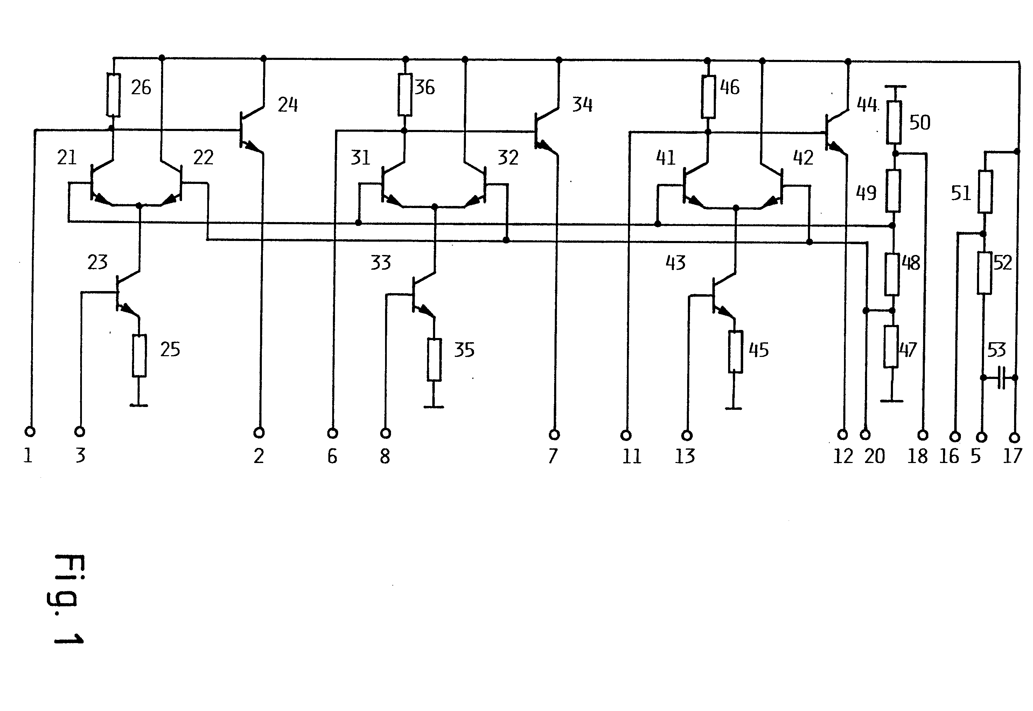

Mit der Schaltungsanordnung nach Fig. 1 kann der Verstärkungsfaktor in drei Kanälen R, G und B eingestellt werden. Die Schaltungen der drei Kanäle R, G, B sind identisch. Im folgenden wird in der Beschreibung auf Kanal R Bezug genommen. Zur Einstellung des Verstärkungsfaktors dienen die beiden emittergekoppelten Transistoren 21 und 22, denen über einen Widerstand 25 und einen dritten Transistor 23 Strom zugeführt wird. Der Transistor 21 weist einen Arbeitswiderstand 26 auf, während der Transistor 22 direkt mit dem positiven Pol 17 der Betriebsspannungsquelle verbunden ist. Die Basis des Transistors 22 ist gemeinsam mit den Basisanschlüssen der Transistoren 32 und 42 der Kanäle G und B über den Anschluß 20 mit einer nicht dargestellten Spannungsquelle verbunden, welche eine konstante Vorspannung liefert. Der Kollektor des Transistors 21 ist über einen als Emitterfolger geschalteten Transistor 24 mit dem Ausgang 2 des Kanals R verbunden. Schließlich ist der Basisanschluß des Transistors 24 noch zu einem weiteren Eingang 1 des Kanals R geführt.

Die anderen Kanäle sind identisch aufgebaut und umfassen die Transistoren 31, 32, 33 und 34 sowie die Widerstände 35 und 36 im Falle des Kanals G und die Transistoren 41, 42, 43 und 44 und die Widerstände 45 und 46 im Falle des Kanals B.

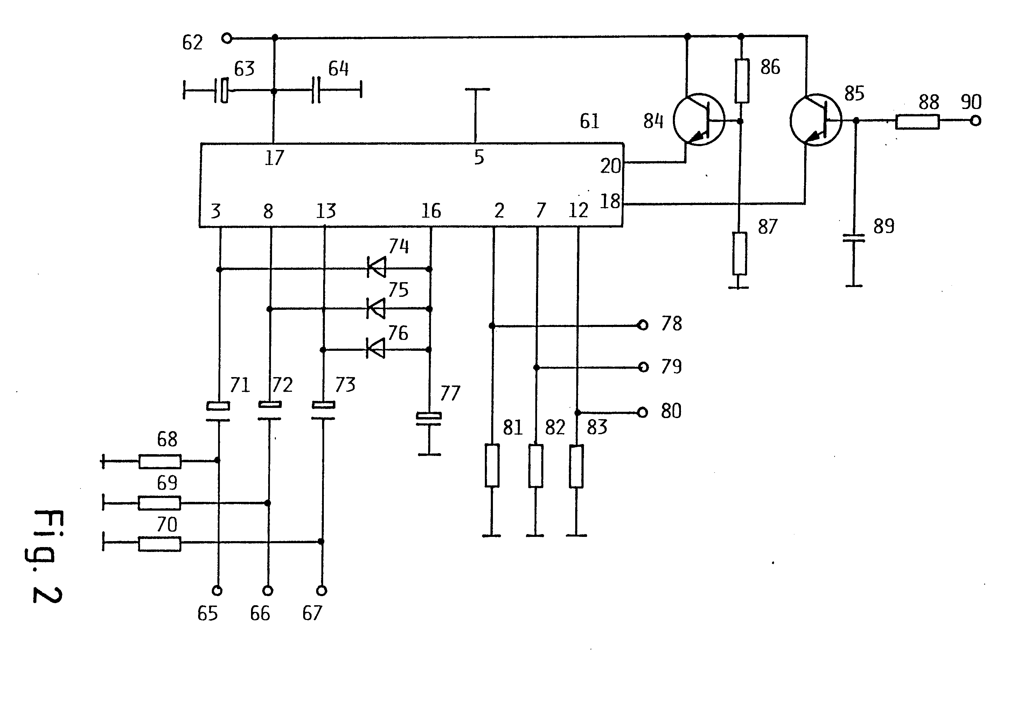

Die Basisanschlüsse der Transistoren 22, 32 und 42 sind gemeinsam mit dem Anschluß 20 zur Zuführung einer konstanten Vorspannung und über den Widerstand 47 mit Massepotential verbunden. Die Basisanschlüsse der Transistoren 21, 31 und 41 sind über einen Widerstand 48 an einen Anschluß 18 zur Zuführung der Einstellspannung für die Verstärkung bzw. den Kontrast angeschlossen, welcher ferner über einen Widerstand 50 mit Massepotential verbunden ist. Schließlich umfaßt die Schaltungsanordnung nach Fig. 1 noch einen Kondensator 53, welcher die Betriebsspannung gegen Massepotential (Anschluß 5) abblockt und einen Spannungsteiler 51, 52 zur Erzeugung einer Vorspannung (Anschluß 16) für die im Zusammenhang mit Fig. 2 beschriebenen Klemmschaltungen.

Der Strom durch den Transistor 23 (bzw. 33 und 43) wird nun entsprechend der bei 3 zugeführten Spannung, also entsprechend dem jeweiligen Farbwertsignal, gesteuert. Dabei sorgt der Gegenkopplungswiderstand 25 für eine ausreichende Linearität. Der somit dem Farbwertsignal entsprechende Strom wird auf die Emitter-Kollektor-Strecken der Transistoren 21 und 22 aufgeteilt. Derjenige Teil, welcher durch den Transistor 21 fließt, hat am Arbeitswiderstand 26 einen Spannungsabfall zur Folge, welcher dem Farbwertsignal multipliziert mit dem Anteil des Stroms durch den Transistor 21 entspricht. Dieser Anteil kann jedoch mit Hilfe der Basisspannungen der Transistoren 21 und 22 von 0 auf 1 gesteuert werden. Diese Steuerung erfolgt nun dadurch, daß der Basis des Transistors 22 wie auch den Basisanschlüssen der Transistoren 32 und 42 über den Anschluß 20 konstantes Potential zugeführt wird. Die Basis des Transistors 21 erhält zusammen mit den Basisanschlüssen der Transistoren 31 und 41 eine Steuerspannung, welche bei 18 zugeführt wird und mit Hilfe des Spannungsteilers 48, 49 herabgesetzt wird. Da zur Steuerung der Transistoren 21, 22 von einem Ende des Einstellbereichs bis zum anderen nur eine geringe Spannungsdifferenz benötigt wird, es jedoch günstiger ist, innerhalb eines Gerätes eine höhere Spannung von einer Baugruppe zu einer anderen zu leiten, ist der Spannungsteiler 48, 49 vorgesehen.

Häufig ist es erforderlich, in vorhandene Signale andere Signale einzublenden, beispielsweise einen Referenzpegel bei einer Cut-Off-Automatik. Mit Hilfe der erfindungsgemäßen Schaltungsanordnung kann eine solche Einblendung in einfacher Weise derart erfolgen, daß über die Anschlüsse 1, 6 und 11 einzublendende Signale zugeführt werden. Wird dabei die Einstellspannung auf Massepotential gelegt, so gelangen nur die zusätzlichen Signale an die Ausgänge. Anderenfalls werden jeweils beide Signale miteinander gemischt. Zur Einblendung eines Referenzpegels können die Anschlüsse 1, 6 und 11 mit Massepotential verbunden werden, wobei unabhängig vom Wert der Einstellspannung und der bei 3, 8 und 13 zugeführten Signale an den Ausgängen Referenzpegel anstehen.

Es ist, ohne den Rahmen der Erfindung zu verlassen, auch möglich, die Basis des Transistors 21 mit einer Transistors 22 eine Einstellspannung zuzuführen. Ferner ist es möglich, beiden Transistoren gegenläufige Steuerspannungen zuzuleiten.

Fig. 2 zeigt eine Ergänzung der Schaltungsanordnung nach Fig. 1, wobei die Schaltungsanordnung nach Fig. 1 schematisch als eine Hybridschaltung 61 dargestellt ist. Die Betriebsspannung wird dem Anschluß 17 der Hybridschaltung 61 von einem Pol 62 einer Betriebsspannungsquelle zugeführt und ist über zwei Kondensatoren 63, 64 abgeblockt. Die Farbwertsignale R, G, B werden über die Eingänge 65, 66, 67, welche mit Abschlußwiderständen 68, 69, 70 verbunden sind, jeweils einer Klemmschaltung zugeführt. Die Klemmschaltungen bestehen in an sich bekannter Weise aus jeweils einem Kondensator 71, 72, 73 und einer Diode 74, 75, 76. Das Klemmpotential wird aus der Hybridschaltung 61 (Anschluß 16) gewonnen. Ein Kondensator 77 dient dazu, die Klemmspannung abzublocken. An die Anschlüsse 2, 7 und 12 der Hybridschaltung 61 sind Ausgänge 78, 79, 80 für die in ihrer Amplitude einstellbaren Farbwertsignale R, G, B und Arbeitswiderstände 81, 82, 83 angeschlossen.

Zur Zuführung der Einstellspannung sowie der Vorspannung dienen zwei weitere Transistoren 84, 85, deren Kollektoren mit dem positiven Pol der Betriebsspannungsquelle und deren Emitter mit dem jeweiligen Anschluß der Hybridschaltung 61 verbunden sind. Die Basis des Transistors 84 wird mit Hilfe eines Spannungsteilers 86, 87 mit konstantem Potential versorgt, während die Basis des Transistors 85 über ein Tiefpaßglied, welches aus einem Widerstand 88 und aus einem Kondensator 89 besteht, mit der bei 90 zugeführten Einstellspannung beaufschlagt ist.

## Ansprüche

1. Schaltungsanordnung mit steuerbarem Verstärkungsfaktor in mehreren Kanälen, insbesondere für die Kontrasteinstellung von Farbfernsehmonitoren, wobei in jedem Kanal zwei emittergekoppelte Transistoren (21, 22; 31, 32; 41, 42) und ein dritter Transistor (23; 33; 43) vorgesehen sind und der Kollektor des jeweils dritten Transistors (23; 33; 43) mit den Emittern des ersten und zweiten Transistors (21, 22; 31, 32; 41, 42) und der Emitter des jeweils dritten Transistors (23; 33; 43) über einen Widerstand (25; 35; 45) mit einem Pol einer Betriebsspannungsquelle verbunden ist, dadurch gekennzeichnet, daß den Basisanschlüssen des jeweils ersten Transistors (21; 31; 41) oder den Basisanschlüssen des jeweils zweiten Transistors (22; 32; 42) jeweils gemeinsam eine Steuerspannung zuführbar ist, daß die Transistoren aus derselben Siliziumscheibe hergestellt sind und daß die Schaltung als Hybridschaltung aufgebaut ist.

2. Schaltungsanordnung nach Anspruch 1, dadurch gekennzeichnet, daß die Basisanschlüsse der jeweils dritten Transistoren (23; 33; 43) Eingänge der Kanäle darstellen und die Kollektoren der jeweils ersten oder zweiten Transistoren über je einen Widerstand (26; 36; 46) mit dem anderen Pol (17) der Betriebsspannungsquelle und über je einen Emitterfolger (24; 34; 44) mit Ausgängen (2; 7; 12) der Kanäle verbunden sind.

3. Schaltungsanordnung nach Anspruch 2, dadurch gekennzeichnet, daß die Kollektoren der jeweils ersten oder zweiten Transistoren weitere Eingänge (1; 6; 11) bilden.

4. Schaltungsanordnung nach Anspruch 3, dadurch gekennzeichnet, daß den Eingängen (3; 8; 13) Klemmschaltungen vorgeschaltet sind.

5. Schaltungsanordnung nach einem der vorangehenden Ansprüche, dadurch gekennzeichnet, daß je ein Kanal für das Rot-, das Grün-und das Blau-Signal vorgesehen ist.

Fig. 1

R.-Nr. 1896

0 224 082

R.-Nr. 1896

Fig. 2